# EUROPÄISCHE PATENTSCHRIFT

(11) **EP 0 602 233 B1**
(45) Veröffentlichungstag und Bekanntmachung des Hinweises auf die Patenterteilung: **25.09.1996**
(21) Anmeldenummer: 93915828.3
(22) Anmeldetag: 07.07.1993
(51) Int. Cl.: C23C 28/02, C23C 14/16

(54) **SCHUTZSCHICHT FÜR TITANBAUTEILE UND VERFAHREN ZU IHRER HERSTELLUNG**
PROTECTIVE COATING FOR TITANIUM COMPONENTS AND PROCESS FOR PRODUCING IT
COUCHE PROTECTRICE POUR COMPOSANTS EN TITANE ET SON PROCEDE DE FABRICATION

(30) Priorität: 07.07.1992 DE 4222210; 04.09.1992 DE 4229600
(43) Veröffentlichungstag der Anmeldung: 22.06.1994
(73) Patentinhaber: MTU MOTOREN- UND TURBINEN-UNION MÜNCHEN GMBH, D-80976 München (DE)
(72) Erfinder: GRUNKE, Richard, D-8000 München 70 (DE); PEICHL, Lothar, D-8060 Dachau (DE); SMARSLY, Wilfried, D-8011 Grasbrunn (DE); EICHMANN, Wolfgang, D-8039 Puchheim (DE)
(74) Vertreter: Baum, Wolfgang, Dipl.-Ing.
(86) Internationale Anmeldenummer: EP9301764
(87) Internationale Veröffentlichungsnummer: WO9401600

(56) Entgegenhaltungen:
- DE-C- 3 742 721
- DE-C- 3 742 944
- US-A- 4 305 998
- DATABASE WPI Week 9009, Derwent Publications Ltd., London, GB; AN 90-062843

## Beschreibung

Die Erfindung betrifft Bauteile aus Titan oder Titanbasislegierungen mit einer Schutzschicht aus einer Zwischenschicht aus Metallen und aus einer Deckschicht und ein Verfahren zu ihrer Herstellung.

Bauteile aus Titanlegierungen finden im Triebwerksbau wegen ihres günstigen Festigkeits- zu Gewichtsverhältnisses Verwendung. Ihr Einsatz ist jedoch im Heißbereich eines Triebwerks und bei Betriebstemperaturen über 550°C aufgrund der hohen Oxidationsanfälligkeit von Titanlegierungen nicht möglich, da sie bei höheren Temperaturen zur Sauerstoffaufnahme neigen und eine Festigkeitsverschlechterung durch Sauerstoffversprödung einsetzt.

In JP-A 02 015164 wird ein Bauteil aus Ti oder Ti-Legierungen offenbart das eine Oberfläche aus einer Pt oder Pt-Al-Phase aufweist, die durch Ionenimplantation gebildet wird, wobei die Phase mit einem Film aus der Reihe der intermetallischen Verbindung TiAl durch Ionenimplantation eines oder mehrerer Ionen von Si, Sc, Y, Ce und HF beschichtet ist.

Aus US-A 4,305,998 ist eine Gruppe von diffusionshemmenden Schichten mit Pt, Nb, Rh oder Ta bekannt, die diffusionshemmend für Metalle wirken, deren Schmelzpunkt unter der Entzündungstemperatur des Substrats (Titan bzw. seine Legierungen) und wesentlich unter dem Schmelzpunkt des Substrats (Titan bzw. seine Legierungen) liegt.

Aus DE-OS 21 53 218 ist bekannt, metallische Bauteile durch eine Aluminiumbeschichtung vor einer Oxidation zu schützen, da Aluminium eine hohe Sauerstoffaffinität aufweist und ein dichtes und temperaturstabiles Oxid bildet. Ein Nachteil einer derartigen Aluminiumschutzschicht auf Titanbauteilen ist, daß das Aluminium bei hohen Betriebstemperaturen an der Grenzfläche in das Titanbauteil eindiffundiert und spröde intermetallische Verbindungen im Grenzbereich zwischen Aluminiumbeschichtung und Titangrundwerkstoff bildet, wodurch die Dauerschwingfestigkeit des Bauteils herabgesetzt wird.

Ferner ist aus DE-PS 39 26 151 bekannt, die Aluminiumdiffusion durch Zwischenschichten aus Edelmetallen zu verhindern. So bestehen titanfeuerhemmende Schutzschichten für Titanbauteile aus einer titanfeuerhemmenden dicken Schicht mit einem hohen Volumenanteil von Aluminium-Partikeln und einer aluminiumdiffusionshemmenden Zwischenschicht aus Edelmetallen. Diese aluminiumhaltigen Deckschichten auf Edelmetallzwischenschichten haben den Nachteil, daß das Aluminium eine geringe Härte aufweist.

Härtere Schutzschichten bilden intermetallische Verbindungen wie sie bei der Diffusion von Aluminium in Titanbauteiloberflächen entstehen. Diese intermetallischen Diffusionsschichten für Titanbauteile haben den Nachteil, daß ihre Bruchdehnung unter 0.2% liegt, so daß bei Dehnungsbelastung des Bauteils die Schutzschicht einreißt und Spannungsrißkorrosionen entlang dieser Risse die Lebensdauer des geschützten Titanbauteils herabsetzen.

Eine Aufgabe der Erfindung ist es, eine gattungsgemäße Schutzschicht anzugeben, die neben einer Sauerstoffschutzwirkung eine hohe Oberflächenhärte und einen Schutz vor Versprödung des Titanbauteils aufweist.

Diese Aufgabe wird erfindungsgemäß dadurch gelöst, daß die Deckschicht eine intermetallische Verbindung von Titan und Aluminium mit Zusätzen von Vanadium, chrom, Mangan, Niob, Molybdän, Tantal oder Wolfram oder Mischungen derselben, die einen Gewichtsanteil bis zu 6% ausmachen umfaßt, und das Metall Platin, Rhodium oder Tantal oder Legierungen derselben ist und mittels Aufstäuben oder Vakuumbedampfen aufgebracht ist.

Der Vorteil dieser Schutzschicht ist, daß eine Versprödung durch Sauerstoff- oder Aluminiumdiffusion in Oberflächennähe des Titanbauteils verhindert wird und eine verminderte Sprödigkeit der intermetallischen Aluminium-Titanverbindung mit den erfindungsgemäßen Zusätzen auftritt, so daß bei unveränderter Oberflächenhärte der intermetallischen Aluminium-Titanverbindung der Schutzschicht in Zusammenwirken von der Deckschicht aus intermetallischen Aluminium-Titanverbindungen mit Zusätzen und der duktilen Zwischenschicht aus Edelmetallen eine Bruchdehnung zwischen 1 und 4% erreicht wird. Mit dieser Erhöhung der Bruchdehnung der Schutzschicht und dem Schutz vor Versprödung wird nicht nur die Einsatztemperatur von Titanbauteilen bis auf 700°C in oxidierendem und korrodierendem Heißgasstrom heraufgesetzt, sondern auch die Lebensdauer von Titanbauteilen erheblich verbessert.

Die Deckschicht besteht vorzugsweise aus 48 bis 50 Atom % Aluminium und 0,5 bis 4 Atom% Vanadium und Rest Titan. Dabei bilden Aluminium und Titan eine Deckschicht aus der intermetallischen Verbindung TiAl. Diese intermetallische Verbindung behindert die Aluminiumkomponente am Austritt aus der TiAl-Deckschicht und ihren Eintritt in die Zwischenschicht, so daß die Wirkung der Zwischenschicht als Diffusionsbarriere für Aluminium gegenüber einer reinen Aluminiumdeckschicht erheblich verstärkt wird. Der Zusatz an Vanadium zwischen 0,5 bis 2 Atom% in der Deckschicht erhöht in Zusammenwirkung mit der Zwischenschicht die Bruchdehnung der Deckschicht und verbessert die Haftung der Deckschicht auf der Zwischenschicht.

In einer weiteren bevorzugten Ausbildung der Erfindung besteht die Deckschicht aus 47 bis 49,5 Atom % Aluminium und 1 bis 6 Atom % Chrom und/oder Mangen und Rest Titan. Auch bei dieser Zusammensetzung ist es vorteilhaft, daß Aluminium und Titan im stöchiometrischen Verhältnis als Metallmolekül vorliegen, wobei der Zusatz Chrom zusätzlich den Oxidationsschutz verstärkt und Mangen oder Chrom haftverbessernde und die Bruchdehnung verbessernde Wirkungen in der Schutzschicht ausbilden.

Darüber hinaus haben sich in Zusammenwirken mit der Deckschicht aus einer intermetallischen Verbindung aus Titan und Aluminium und einer Metallzwischenschicht aus Platin, Rhodium oder Tantal oder Legierungen derselben die Zusätze von 1 bis 4 Atom % Niob, Molybdän, Tantal und/oder Wolfram zum TiAl bewährt.

Schließlich konnte festgestellt werden, daß Zusätze aus 2 Atom % Chrom und 2 Atom % Niob bei vorzugsweise jeweils 48 Atom % Aluminium und 48 Atom % Titan hervorragende Eigenschaftten in Bezug auf Verbesserung von Haftung und Bruchdehnung der intermetallischen Deckschicht liefern.

In einer weiteren bevorzugten Ausbildung der Erfindung ist der Sauerstoffgehalt der Deckschicht kleiner 700 ppm, so daß die Deckschicht duktil ist und vorteilhaft keine Sauerstoffquelle für Sauerstoffdiffusionen bildet.

In einer bevorzugten Ausbildung der Erfindung weist die Zwischenschicht eine Schichtdicke von 0,1 bis 100 µm auf. Die Dicke der Zwischenschicht kann vorteilhaft der Einsatztemperatur und dem erfindungsgemäßen Zwischenschichtmaterial Platin, Rhodium oder Tantal oder Legierungen derselben angepaßt werden, so daß eine sichere Diffusionsbarriere gegen Aluminium- oder Sauerstoffdiffusion geschaffen wird.

Zur Härtung der Oberfläche des Bauteils reicht vorzugsweise eine Dicke der Deckschicht von mindestens 0,1 µm aus. Damit sich die Deckschicht in Zusammenwirken mit der Zwischenschicht den Dehnungen des Bauteils aus Titan anpassen kann, liegt vorzugsweise die obere Grenze der Deckschichtdicke bei 100 µm.

Eine weitere Aufgabe besteht darin, ein Verfahren zur Herstellung einer Schutzschicht für Bauteile aus Titan oder Titanlegierungen mit einer Zwischenschicht und einer Deckschicht aus einer intermetallischen Verbindung von Titan- und Aluminium anzugeben.

Diese Aufgabe wird durch ein Verfahren mit folgenden Verfahrensschritten gelöst.

Zunächst wird eine Metallschicht durch Aufstäuben oder Vakuumbedampfen aufgebracht und anschließend wird eine Deckschicht aus einer intermetallischen Verbindung von Titan und Aluminium vorzugsweise aus TiAl mit den Zusätzen von Vanadium, Chrom, Mangan, Niob, Molybdän, Tantal oder Wolfram oder Mischungen derselben aufgebracht und schließlich das Bauteil mit diesen aufgebrachten Schichten spannungsfrei geglüht.

Der Vorteil dieses Verfahrens liegt darin, daß die Beschichtung des Bauteils sowohl in Bezug auf die Zusammensetzung der Beschichtung als auch in Bezug auf die Einheit der Beschichtung und die Dicke der Beschichtung äußerst präzise und reproduzierbar durchgeführt werden kann.

In einer bevorzugten Durchführung des Verfahrens wird das Spannungsfreiglühen bei 400 bis 1000°C, vorzugsweise bei 600 bis 850° für 0,1 bis 100 h, vorzugsweise 1 bis 5 Stunden durchgeführt.

Der bevorzugte Temperaturbereich des Spannungsfreiglühens richtet sich nach der maximalen Einsatz- oder Betriebstemperatur bei der das Bauteil zuverlässig funktionieren soll. Der bevorzugte Temperaturbereich für das Spannungsfreiglühen ist deshalb vorteilhaft um mindestens 20°C höher zu wählen als die maximale Einsatz- oder Betriebstemperatur.

Bevorzugte Verfahren zum Aufbringen der Beschichtung aus Zwischenschicht und Deckschicht sind Aufstäuben unter kontrollierten Umgebungsbedingungen, Niederdruckplasmaspritzen oder Vakuumbedampfen. Diese Verfahren haben den Vorteil, daß sie in äußerst reiner Umgebung ausgeführt werden, so daß keine Fehlstellen oder Fremdatome und besonders niedrige Sauerstoffkonzeptionen in die Schutzschicht eingebaut werden.

### Beispiel 1

Das Schaufelblatt einer Triebwerksleitschaufel aus Titan mit einer Wandstärke von 1,2 mm weist als Schutzschicht eine Zwischenschicht aus der Legierung Platin/10 % Rhodium auf und eine Deckschicht aus der intermetallischen Verbindung TiAl mit Zusätzen von 2 Atom % Chrom und 2 Atom % Niob bei einem Sauerstoffgehalt von unter 200 ppm. Die Zwischenschicht ist dabei 3 µm dick und die Deckschicht 20 µm. Die Bruchdehnung der Schutzschicht wurde mit 3,2 % bei Raumtemperatur gemessen.

### Beispiel 2

Der gehäuseseitige Mantelring einer Triebwerksstufe besteht aus Titan mit einer Schutzschicht aus Tantal als Zwischenschicht in einer Dicke von 1,5 µm und einer Deckschicht von 35 µm aus TiAl mit 4 Atom % Niob, Molybdän, Tantal und Wolfram, wobei der Anteil an Tantal 2 Atom %, Niob 1,5 Atom % und Molybdän und Wolfram zusammen 0,5 Atom % ist. Der Sauersottgehalt ist 600 ppm. Die Bruchdehnung der Schutzschicht wurde mit 2,5% bei Raumtemperatur gemessen. Der Mantelring wurde für eine thermische Belastung bis 650°C ausgelegt.

### Beispiel 3

Das Schaufelblatt einer hohlen Triebwerkslaufschaufel aus Titan mit einer Wandstärke von 0,7 mm weist als Schutzschicht eine Zwischenschicht aus reinem Platin auf und eine Deckschicht aus der intermetallischen Verbindung TiAl mit Zusätzen von 2 Atom % Chrom und 0,5 Atom % Mangan bei einem Sauerstoffgehalt von unter 100 ppm. Die Zwischenschicht ist dabei 1 µm dick und die Deckschicht 1,2 µm. Die Bruchdehnung der Schutzschicht wurde mit 4% bei Raumtemperatur gemessen.

### Beispiel 4

Auf das Schaufelblatt einer Triebwerksschaufel wird zunächst eine Metallschicht als Zwischenschicht aus Platin, 13 % Rhodium durch Aufstäuben aufgebracht. Dabei wird das Dickenwachstum der Zwischenschicht überwacht und das Aufstäuben bei einer Dicke von 1 µm unterbrochen. Anschließend wird die Deckschicht aus einer intermetallischen Verbindugn von Titan und Aluminium vorzugsweise aus TiAl mit metallischen Zusätzen aufgebracht, indem eine Kathode aus diesem Material zerstäubt wird und der Prozeß beim Erreichen einer Dicke von 1,3 µm beendet wird. Beide Aufstäubungsschritte werden in derselben Anlage, die mit entsprechenden Kathodenmaterialien bestückt ist, durchgeführt. Abschließend wird das Bauteil mit den aufgebrachten Schichten bei 750°C für 1 h unter Inertgas spannungsfrei geglüht. Das Glühen unter Inertgas wird für Glühtemperaturen über 700°C erforderlich, da Schichten aus intermetallischen Verbindungen bei Temperaturen über 700°C zunehmend einer Sauerstoffversprödung unterliegen.

## Patentansprüche

1. Bauteil aus Titan oder Titanbasislegierungen mit einer Schutzschicht aus einer Zwischenschicht aus Metallen und aus einer Deckschicht, wobei die Deckschicht eine intermetallische Verbindung von Titan- und Aluminium mit Zusätzen von Vanadium, Chrom, Mangan, Niob, Molybdän, Tantal oder Wolfram oder Mischungen derselben, die einen Gewichtsanteil bis zu 6% ausmachen, umfaßt und das Metall Platin, Rhodium oder Tantal oder Legierungen derselben ist und mittels Aufstäuben oder Vakuumbedampfen aufgebracht ist.

2. Bauteil nach Anspruch 1, dadurch gekennzeichnet, daß die Deckschicht einen Sauerstoffgehalt kleiner 700 ppm aufweist.

3. Bauteil nach Anspruch 1 oder 2, dadurch gekennzeichnet, daß die Deckschicht aus 48 bis 50 Atom % Aluminium und 0,5 bis 4 Atom% Vanadium und Rest Titan besteht.

4. Bauteil nach Anspruch 1 oder 2, dadurch gekennzeichnet, daß die Deckschicht aus 47 bis 49,5 Atom % Aluminium und 1 bis 6 Atom % Chrom und/oder Mangan und Rest Titan besteht.

5. Bauteil nach Anspruch 1 oder 2, dadurch gekennzeichnet, daß die Deckschicht aus 48 Atom % Aluminium und 2 Atom % Chrom und 2 Atom % Niob und Rest Titan besteht.

6. Bauteil nach Anspruch 1 oder 2, dadurch gekennzeichnet, daß die Deckschicht aus 48 bis 49,5 Atom % Aluminium und 1 bis 4 Atom % Niob, Molybdän, Tantal und/oder Wolfram oder Mischungen derselben und Rest Titan besteht.

7. Bauteil nach einem der Ansprüche 1 bis 6, dadurch gekennzeichnet, daß die Zwischenschicht eine Schichtdicke von 0,1 bis 100 µm aufweist.

8. Bauteil nach einem der Ansprüche 1 bis 7, dadurch gekennzeichnet, daß die Deckschicht eine Dicke von 0,1 bis 100 µm aufweist.

9. Verfahren zur Herstellung einer Schutzschicht für Bauteile aus Titan oder Titanbasislegierungen mit einer Zwischenschicht und einer Deckschicht aus einer intermetallischen Verbindung von Titan und Aluminium, wobei zunächst eine Metallschicht durch Aufstäuben oder Vakuumbedampfen und anschließend eine Deckschicht aus einer intermetallischen Verbindung von Titan und Aluminium mit metallischen Zusätzen van Vanadium, Chrom, Mangan, Niob, Molybdän, Tantal oder Wolfram oder Mischungen derselben die einen Gewichtsanteil bis zu 6% ausmachen, aufgebracht und schließlich das Bauteil mit aufgebrachten Schichten spannungsfrei geglüht wird.

10. Verfahren nach Anspruch 9, dadurch gekennzeichnet, daß das Spannungsfreiglühen bei 400 bis 1000°C, vorzugsweise bei 600 bis 800°C für 0,1 bis 100 Stunden, vorzugsweise 1 bis 5 Stunden durchgeführt wird.

11. Verfahren nach Anspruch 9 oder 10, dadurch gekennzeichnet, daß die Deckschicht durch Aufstäuben, Niederdruckplasmaspritzen oder durch Vakuumbedampfen aufgebracht wird.

## Claims

1. A component made of titanium or titanium-based alloys having a protective layer comprising an intermediate layer of metals and an outer layer, wherein the outer layer comprises an intermetallic compound of titanium and aluminium with additions of vanadium, chromium, manganese, niobium, molybdenum, tantalum or tungsten or mixtures thereof, constituting a proportion by weight of up to 6%, and the metal is platinum, rhodium or tantalum or alloys thereof and is applied by means of atomisation or vacuum deposition.

2. A component according to claim 1, characterised in that the outer layer has an oxygen content of less than 700 ppm.

3. A component according to claim 1 or 2, characterised in that the outer layer comprises 48 to 50 atom % aluminium and 0.5 to 4 atom % vanadium and the remainder titanium.

4. A component according to claim 1 or 2, characterised in that the outer layer comprises 47 to 49.5 atom % aluminium and 1 to 6 atom % chromium and/or manganese and the remainder titanium.

5. A component according to claim 1 or 2, characterised in that the outer layer comprises 48 atom % aluminium and 2 atom % chromium and 2 atom % niobium and the remainder titanium.

6. A component according to claim 1 or 2, characterised in that the outer layer comprises 48 to 49.5 atom % aluminium and 1 to 4 atom % niobium, molybdenum, tantalum and/or tungsten or mixtures thereof and the remainder titanium.

7. A component according to any one of claims 1 to 6, characterised in that the intermediate layer has a thickness of 0.1 to 100 µm.

8. A component according to any one of claims 1 to 7, characterised in that the outer layer has a thickness of 0.1 to 100 µm.

9. A process for the preparation of a protective layer for components made of titanium or titanium-based alloys, comprising an intermediate layer and an outer layer of an intermetallic compound of titanium and aluminium, wherein firstly a metal layer is applied by atomisation or vacuum deposition and then an outer layer of an intermetallic compound of titanium and aluminium is applied, with metal additions of vanadium, chromium, manganese, niobium, molybdenum, tantalum or tungsten or mixtures thereof, constituting a proportion by weight of up to 6%, and finally the component with the applied layers is stress-free annealed.

10. A process according to claim 9, characterised in that the stress-free annealing is carried out at 400°C to 1000°C, preferably 600°C to 800°C for 0.1 to 100 hours, preferably 1 to 5 hours.

11. A process according to claim 9 or 10, characterised in that the outer layer is applied by atomisation, low-pressure plasma spraying or by vacuum deposition.

## Revendications

1. Pièce en titane ou en alliages de titane comportant une couche de protection constituée d'une couche intermédiaire en métaux et d'une couche de recouvrement, la couche de recouvrement contenant un composé intermétallique de titane et d'aluminium avec des additifs de vanadium, de chrome, de manganèse, de niobium, de molybdène, de tantale ou de tungstène ou des mélanges de ceux-ci, dont le pourcentage en poids peut aller jusqu'à 6 %, et le métal étant du platine, du rhodium ou du tantale ou des alliages de ceux-ci, et étant déposée par diffusion ou en phase vapeur sous vide.

2. Pièce selon la revendication 1, caractérisée en ce que la teneur en oxygène de la couche de recouvrement est inférieure à 700 ppm.

3. Pièce selon la revendication 1 ou 2, caractérisée en ce que la couche de recouvrement est constituée de 48 à 50 % en atome d'aluminium et de 0,5 à 4 % en atome de vanadium, le reste étant du titane.

4. Pièce selon la revendication 1 ou 2, caractérisée en ce que la couche de recouvrement est constituée de 47 à 49,5 % en atome d'aluminium et de 1 à 6 % en atome de chrome et/ou de manganèse, le reste étant du titane.

5. Pièce selon la revendication 1 ou 2, caractérisée en ce que la couche de recouvrement est constituée de 48 % en atome d'aluminium, de 2 % en atome de chrome et de 2 % en atome de niobium, le reste étant du titane.

6. Pièce selon la revendication 1 ou 2, caractérisée en ce que la couche de recouvrement est constituée de 48 à 49,5 % en atome d'aluminium et de 1 à 4 % en atome de niobium, de molybdène, de tantale et/ou de tungstène ou de mélanges de ceux-ci, le reste étant du titane.

7. Pièce selon l'une quelconque des revendications 1 à 6, caractérisée en ce que l'épaisseur de la couche intermédiaire est comprise entre 0,1 et 100 µm.

8. Pièce selon l'une quelconque des revendications 1 à 7, caractérisée en ce que l'épaisseur de la couche de recouvrement est comprise entre 0,1 et 100 µm.

9. Procédé destiné à la fabrication d'une couche de protection pour des pièces en titane ou en alliages de titane, comportant une couche intermédiaire et une couche de recouvrement en un composé intermétallique de titane et d'aluminium, une couche métallique étant dans un premier temps déposée par diffusion ou en phase vapeur sous vide, et ensuite une couche de recouvrement en un composé intermétallique de titane et d'aluminium avec des additifs métalliques de vanadium, de chrome, de manganèse, de niobium, de molybdène, de tantale ou de tungstène ou des mélanges de ceux-ci, qui représentent un pourcentage en poids pouvant aller jusqu'à 6 %, et pour finir la pièce sur laquelle sont appliquées ces couches est soumise à un recuit de détensionnement.

10. Procédé selon la revendication 9, caractérisé en ce que le recuit de détensionnement est effectué à une température de 400 à 1000 °C, de préférence de 600 à 800 °C pendant 0,1 à 100 heures, de préférence pendant 1 à 5 heures.

11. Procédé selon la revendication 9 ou 10, caractérisé en ce que la couche de recouvrement est déposée par pulvérisation, pulvérisation au plasma basse pression ou en phase vapeur sous vide.
